# DEMANDE DE BREVET EUROPEEN

(11) **EP 2 389 050 A1**
(43) Date de publication de la demande: **23.11.2011**
(21) Numéro de dépôt: 11166168.2
(22) Date de dépôt: 16.05.2011
(51) Int. Cl.: H05K 1/14, H05K 3/36

(54) **Assemblage d'au moins deux cartes électriques**

(30) Priorité: 21.05.2010 FR 1053992
(71) Demandeur: VALEO VISION, 93012 Bobigny (FR)
(72) Inventeur: Duarte, Marc, 93250 Villemomble (FR); Thierry, Benjamin, 10190 Palis (FR); Touzet, Benjamin, 92200 Neuilly sur Seine (FR)

(57) **Abrégé**

L'invention concerne un assemblage (1) d'au moins deux cartes électriques (2,3), notamment de deux cartes de circuit imprimé, les deux cartes étant soudées entre elles, caractérisé par le fait que l'une au moins des deux cartes comporte au moins un orifice (4) laissant apparaître une trace (10) de la soudure.

## Description

L'invention concerne notamment un assemblage d'au moins deux cartes électriques, notamment de deux cartes de circuit imprimé, assemblage utilisé notamment dans un véhicule l'automobile.

Le brevet US 6 919 529 décrit un procédé pour fournir une connexion électrique entre une carte de circuit imprimé flexible et un composant électrique. Ce procédé utilise un laser pour la soudure. Ce procédé présente l'inconvénient qu'il ne permet pas de contrôler aisément la qualité de la connexion électrique.

L'invention vise notamment à proposer un procédé de connexion électrique amélioré.

L'invention a ainsi pour objet un assemblage d'au moins deux cartes électriques, notamment de deux cartes de circuit imprimé, les deux cartes étant soudées entre elles, caractérisé par le fait que l'une au moins des deux cartes comporte au moins un orifice laissant apparaître une trace de la soudure.

Grâce à l'invention, du fait de la présence d'un orifice laissant apparaître une trace de la soudure, il est possible de réaliser aisément un contrôle de la qualité de la soudure, par exemple par un moyen automatique standard d'inspection optique.

L'orifice laissant apparaître la trace de la soudure peut par exemple être sensiblement circulaire ou de toute autre forme appropriée.

Cet orifice peut avoir un pourtour fermé et être à distance de la bordure de la carte correspondante ou, en variante, cet orifice peut être ouvert sur cette bordure et former par exemple une fente.

L'invention permet également d'avoir un assemblage à coût réduit car celui-ci, si on le souhaite, ne nécessite pas de pièces supplémentaires pour la connexion.

En outre, l'invention permet une bonne répétabilité des opérations et assure une tenue mécanique satisfaisante de l'assemblage.

On entend par 'soudure', selon la présente invention, notamment une opération pour assembler deux éléments à l'aide d'un métal d'apport que l'on fait fusionner en température. On entend par 'soudure' également une brasure.

Dans un exemple de mise en oeuvre de l'invention, l'une au moins des cartes est une carte de circuit imprimé flexible.

En variante, l'une au moins des cartes est une carte de circuit imprimé rigide.

Si on le souhaite, les deux cartes sont des cartes de circuit imprimé rigides ou, en variante, les deux cartes sont des cartes de circuit imprimé flexibles.

La trace de soudure peut correspondre à un dépôt de matière de soudure, par exemple de l'étain. Cette trace de soudure peut par exemple avoir la forme d'un ménisque.

Dans un exemple de mise en oeuvre de l'invention, le dépôt de matière de soudure s'étend à travers l'orifice de la carte.

De préférence, chaque carte comporte au moins une piste conductrice, et le dépôt de matière de soudure joint la piste conductrice de l'une des cartes à la piste conductrice de l'autre carte.

Le cas échéant, l'une au moins des cartes comporte une pluralité d'orifices, chacun laissant apparaître une trace de la soudure.

De préférence, l'une au moins des cartes, laquelle est par exemple rigide, comporte au moins un picot, par exemple une pluralité de picots, agencé(s) pour s'engager dans l'orifice de l'autre carte, et le dépôt de matière de soudure est par exemple en contact avec ce picot.

L'invention peut, le cas échéant, permettre, du fait de la présence du ou des picots, d'éviter un problème de brûlure.

La présence d'un ou plusieurs picots permet également un positionnement précis de l'une des cartes par rapport à l'autre, préalablement à la soudure.

La présence d'un ou plusieurs picots peut encore permettre de faciliter l'opération de soudure, et améliorer la qualité de la soudure (forme de ménisque du métal fondu). La soudure peut par exemple s'avérer bien propre.

Si on le souhaite, les picots sont alignés sur une ligne droite.

Par exemple, le ou les picots sont soudés sur la carte de circuit imprimé qui les porte.

Le cas échéant, le picot de l'une des cartes comporte un épaulement sur lequel repose l'autre carte.

Si on le souhaite, l'assemblage est dépourvu d'une couche de résine, notamment thermodurcissable, déposée entre les deux cartes de circuit imprimé pour les maintenir assemblées.

Avantageusement, une fois les cartes assemblées, le ou les picots font saillie à travers le ou les orifices correspondants.

En variante, le ou les orifices de l'une des cartes reçoivent, une fois les cartes assemblées, uniquement de la matière de soudure, notamment sans présence d'un picot.

Dans un exemple de mise en oeuvre de l'invention, l'assemblage comporte au moins un organe de maintien, par exemple réalisé en matière plastique, agencé pour maintenir, au moins temporairement, l'une des cartes de circuit imprimé contre l'autre, notamment au moins préalablement à la soudure.

Le cas échéant, cet organe de maintien peut être retiré de l'assemblage après la soudure.

Les cartes de circuit imprimé sont de préférence maintenues assemblées exclusivement par la soudure et les picots.

Le cas échéant, l'assemblage est dépourvu d'un organe de maintien, notamment un raidisseur, pour maintenir l'une des cartes de circuit imprimé contre l'autre de manière permanente après la soudure.

Par exemple, l'une des cartes de circuit imprimé, notamment celle étant rigide, porte au moins un composant électronique, notamment porte au moins une source de lumière, notamment au moins une LED.

Dans un exemple de mise en oeuvre de l'invention, l'une des cartes de circuit imprimé est en contact avec un organe dissipateur de chaleur, par exemple comportant des ailettes de refroidissement.

De préférence, l'assemblage est agencé pour être monté dans un dispositif d'éclairage et/ou de signalisation de véhicule automobile.

L'invention a également pour objet une carte de circuit imprimé comportant au moins une piste conductrice et un picot en contact électrique avec cette piste, ce picot étant par exemple soudé sur cette piste.

L'invention a encore pour objet un procédé pour réaliser une connexion électrique entre deux cartes de circuit imprimé, le procédé comportant les étapes suivantes :
- Rapprocher les cartes de circuit imprimé,
- réaliser une soudure laser pour connecter électriquement les deux cartes de circuit imprimé.

Le cas échéant, après la soudure, la ou les traces de soudure est/sont inspectée(s) de manière optique, par exemple en utilisant de la lumière visible.

L'invention pourra être mieux comprise à la lecture de la description détaillée qui va suivre, d'exemples de mise en oeuvre non limitatifs de l'invention, et à l'examen du dessin annexé, sur lequel :
- la figure 1 représente, schématiquement et partiellement, en perspective, un assemblage selon un exemple de mise en oeuvre de l'invention,
- la figure 2 illustre, schématiquement et partiellement, suivant une coupe selon II-II l'assemblage de la figure 1,
- la figure 3 représente, schématiquement et partiellement, en perspective, un assemblage selon un autre exemple de mise en oeuvre de l'invention,
- la figure 4 illustre, schématiquement et partiellement, suivant une coupe selon IV-IV, l'assemblage de la figure 3,
- la figure 5 représente, schématiquement et partiellement, en perspective, un assemblage selon encore un autre exemple de mise en oeuvre de l'invention, et
- la figure 6 illustre, schématiquement et partiellement, suivant une coupe selon VI-VI, l'assemblage de la figure 5.

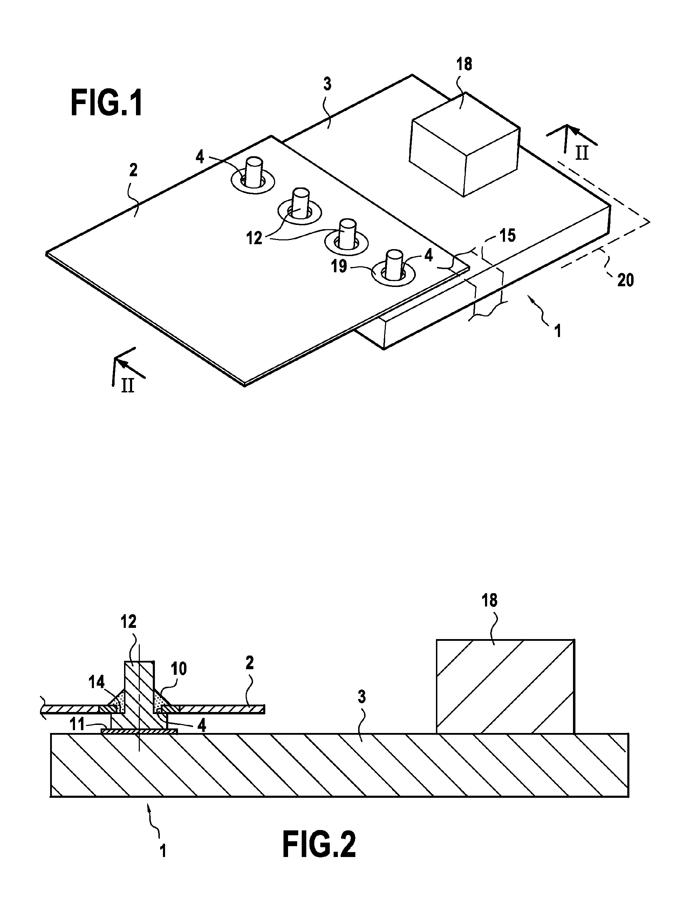

On a représenté sur les figures 1 et 2 un assemblage 1 de deux cartes électriques 2 et 3, à savoir deux cartes de circuit imprimé, les deux cartes étant soudées entre elles.

La carte 2 comporte une pluralité d'orifices circulaires 4, alignés sur un segment de droite, laissant apparaître chacune une trace 10 de la soudure (voir figure 2).

Dans l'exemple décrit, la carte de circuit imprimé 2 est flexible, et la carte 3 est rigide.

La trace de soudure 10 correspond à un dépôt de matière de soudure, par exemple de l'étain. Cette trace de soudure apportée lors de la soudure peut par exemple avoir la forme d'un ménisque.

Le dépôt de matière de soudure s'étend à travers l'orifice de la carte.

Chaque carte 2 et 3 comporte une pluralité de pistes conductrices 11, et le dépôt de matière de soudure joint la piste conductrice de l'une des cartes à la piste conductrice de l'autre carte.

La carte rigide 3 comporte une pluralité de picots 12 chacun agencé pour s'engager dans l'un des orifices 4 de l'autre carte 2, et le dépôt de matière de soudure est en contact avec ce picot 12.

Les picots 12 sont alignés sur une ligne droite.

Par exemple, les picots 12 sont soudés sur la carte de circuit imprimé 3 qui les porte.

Chaque picot 12 comporte un épaulement 14 sur lequel repose l'autre carte 2.

Une fois les cartes assemblées, les picots 12 font saillie à travers les orifices 4 correspondants.

Ces orifices 4 sont bordés chacun par un anneau par exemple en cuivre 19, anneau 19 qui est en contact avec le métal d'apport de la soudure.

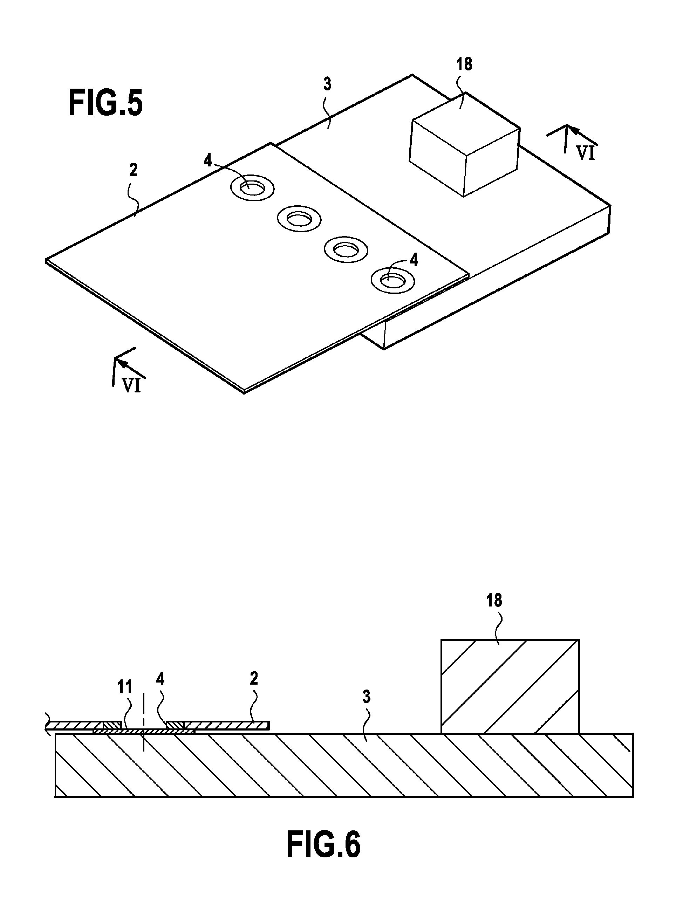

En variante, comme illustré sur les figures 5 et 6, les orifices 4 de la carte 2 reçoivent, une fois les cartes 2 et 3 assemblées, uniquement de la matière de soudure, sans présence d'un picot.

La carte 3 ne porte aucun picot de connexion.

Dans un exemple de mise en oeuvre de l'invention, l'assemblage 1 comporte au moins un organe de maintien 15 (représenté très schématiquement en pointillés sur la figure 1), par exemple réalisé en matière plastique, agencé pour maintenir l'une des cartes de circuit imprimé contre l'autre, notamment au moins préalablement à la soudure.

La carte de circuit imprimé 3 porte au moins un composant électronique 18, notamment porte au moins une source de lumière, notamment au moins une LED.

Dans l'exemple de la figure 1, la carte de circuit imprimé 3 est en contact avec un organe dissipateur de chaleur 20, par exemple comportant des ailettes de refroidissement.

L'assemblage 1 est agencé pour être monté dans un dispositif d'éclairage et/ou de signalisation de véhicule automobile, par exemple capable de produire un faisceau code et/ou route.

Bien entendu, l'invention n'est pas limitée aux exemples de mise en oeuvre décrits ci-dessus.

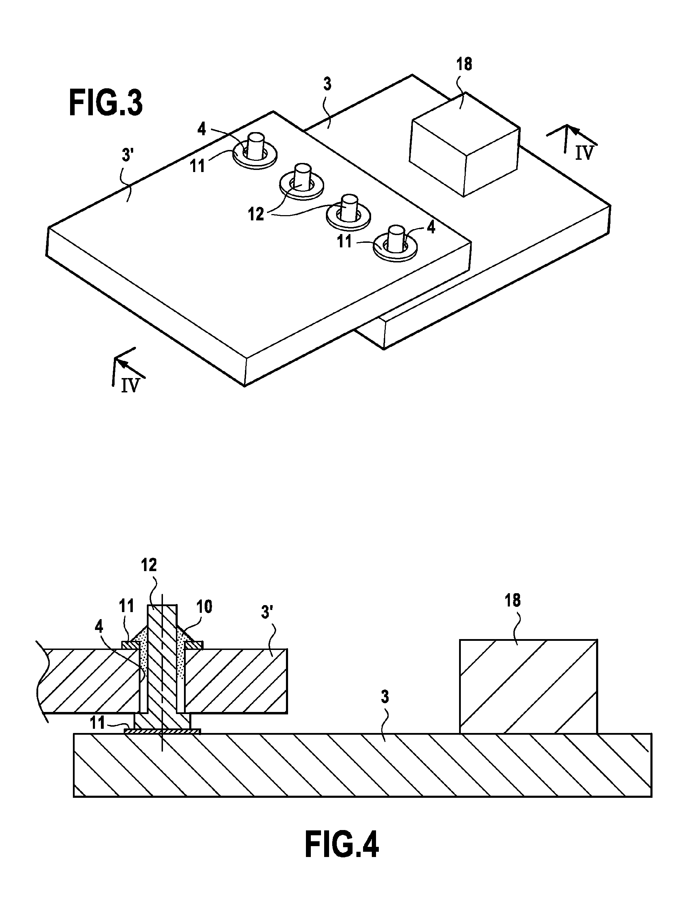

Par exemple, comme illustré sur les figures 3 et 4, l'assemblage peut comporter deux cartes de circuit imprimé rigides 3 et 3'.

## Revendications

1. Assemblage (1) d'au moins deux cartes électriques (2,3), notamment de deux cartes de circuit imprimé, les deux cartes étant soudées entre elles, **caractérisé par le fait que** l'une au moins des deux cartes comporte au moins un orifice (4) laissant apparaître une trace (10) de la soudure.

2. Assemblage selon la revendication précédente, **caractérisé par le fait que** l'une au moins des cartes est une carte de circuit imprimé flexible (3).

3. Assemblage selon l'une des revendications précédentes, **caractérisé par le fait que** l'une au moins des cartes est une carte de circuit imprimé rigide (2).

4. Assemblage selon l'une des revendications précédentes, **caractérisé par le fait que** le dépôt de matière de soudure s'étend à travers l'orifice de la carte.

5. Assemblage selon l'une des revendications précédentes, **caractérisé par le fait que** chaque carte comporte au moins une piste conductrice (11) et le dépôt de matière de soudure joint la piste conductrice de l'une des cartes à la piste conductrice de l'autre carte.

6. Assemblage selon l'une des revendications précédentes, **caractérisé par le fait que** l'une au moins des cartes, laquelle est par exemple rigide, comporte au moins un picot, par exemple une pluralité de picots, agencé(s) pour s'engager dans l'orifice (4) de l'autre carte, et le dépôt de matière de soudure est en contact avec ce picot.

7. Assemblage selon la revendication précédente, **caractérisé par le fait que** le ou les picots (12) sont soudés sur la carte de circuit imprimé correspondante.

8. Assemblage selon l'une des revendications 6 et 7, **caractérisé par le fait que**, une fois les cartes assemblées, le ou les picots (12) font saillie à travers le ou les orifices correspondants.

9. Assemblage selon l'une des revendications 1 à 5 **caractérisé par le fait que** le ou les orifices de l'une des cartes reçoivent, une fois les cartes assemblées, uniquement de la matière de soudure, notamment sans présence d'un picot.

10. Assemblage selon l'une des revendications précédentes, **caractérisé par le fait qu'**il comporte au moins un organe de maintien, par exemple réalisé en matière plastique, agencé pour maintenir l'une des cartes de circuit imprimé contre l'autre.

11. Assemblage selon l'une des revendications précédentes, **caractérisé par le fait que** l'une des cartes de circuit imprimé, notamment étant rigide, porte au moins un composant électronique, notamment porte au moins une source de lumière, notamment au moins une LED (18).

12. Assemblage selon l'une des revendications précédentes, agencé pour être monté dans un dispositif d'éclairage et/ou de signalisation de véhicule automobile.

13. Carte de circuit imprimé comportant au moins une piste conductrice et un picot en contact électrique avec cette piste, ce picot (12) étant par exemple soudé sur cette piste.

14. Procédé pour réaliser une connexion électrique entre deux cartes de circuit imprimé, le procédé comportant les étapes suivantes:
- rapprocher les cartes de circuit imprimé,
- réaliser une soudure laser pour connecter électriquement les deux cartes de circuit imprimé.

15. Procédé selon la revendication précédente, **caractérisé par le fait que**, après la soudure, la ou les traces de soudure est/sont inspectée(s) de manière optique.
